# EUROPEAN PATENT APPLICATION

(11) **EP 4 387 127 A1**
(43) Date of publication of application: **19.06.2024**
(21) Application number: 22212993.4
(22) Date of filing: 13.12.2022
(51) Int. Cl.: H04B 17/20, G01R 23/16

(54) **ONLINE OR OFFLINE DETECTION OF THE PRESENCE AND THE POSITION OF ONE OR MORE SIGNALS IN A DATA STREAM**

(71) Applicant: Rohde & Schwarz GmbH & Co. KG, 81671 München (DE)
(72) Inventor: Buhl, Ulrike, 85567 Grafing (DE); Widmann, Sebastian, 85652 Pliening (DE); Frick, Alexander, 85635 Höhenkirchen (DE)
(74) Representative: Rupp, Christian

(57) **Abstract**

A device for combined detection of a signal in a data-stream supplied to the device is provided. The device has a computing module which is configured to, in a first queue, run, in increments of timeslots, an analytical signal detection algorithm on the data-stream to obtain a first signal detection result. The computing module is further configured to, in a second, parallel queue, run in increments of timeslots, a machine learning signal detection algorithm on the data-stream to obtain a plurality of signal detection results and to select a second signal detection result out of the plurality of signal detection results based on a selection criterion. The computing module is also configured to determine a compared signal detection result based on the first result, the second result, and a comparison criterion, and combine a plurality of consecutive compared results to detect the signal in the data-stream supplied.

## Description

### FIELD OF THE INVENTION

The invention relates to a device for detection of signals in a data stream, in particular by using combined machine learning and analytical algorithms. The invention also relates to a corresponding method and computer program.

### TECHNICAL BACKGROUND

To detect a signal (e.g., a radio frequency (RF) signal) in an observed data stream (e.g., a in terms of IQ data, spectrum or a spectrogram), conventional solutions make use of analytical measurement means, such as an analytical signal detection algorithm, which operates on the data stream to obtain a signal detection result. That is, the signal detection result obtained according to the algorithm indicates the presence of the signal.

"Signal" is to be understood as a non-noise time/frequency resource.

"Online" means a processing during the ongoing reception of a wire-bound or wirelessly data stream.

"Offline" means a processing delayed with regard to the reception of such data stream e.g., by processing a stored sample of the data stream.

"Detecting a signal" is to be understood as identifying frequency/time resources which are estimated as being non-noise components of the data stream.

To obtain the signal detection result of unknown data streams, conventional solutions apply the same analytical method repeatedly for every new data stream, that is, they detect the signal of the data stream "from scratch" every time. This may lead to inaccurate results and a resourceintensive measurement process.

### SUMMARY OF THE INVENTION

Against this background, the object of the present invention is to provide a detection (presence and frequency/time position) of one or more signals in a noise (non-signal components)-containing data stream as a result of a combined approach which at the same time uses analytical algorithms and machine learning, e.g., implemented via an artificial neural network. Thus, both the advantages of analytical algorithms and machine learning algorithms can be exploited, and potential drawbacks of the respective other algorithm can be avoided.

The invention is set out in the appended set of claims. The object is solved by the features of the independent claims. The dependent claims contain further developments.

A first aspect of the present invention provides a device for the detection of the presence and the time/frequency position of one or more signals in a data stream, which also contains noise, supplied to the device, wherein the device has a computing module which is configured to: in a first queue, run, in increments of timeslots, an analytical signal detection algorithm on the data stream to obtain a first signal detection result; in a second, parallel queue, run in increments of timeslots, a machine learning signal detection on the data stream to obtain a plurality of signal detection results and to select a second signal detection result out of the plurality of signal detection results based on a selection criterion; determine a compared signal detection result based on the first signal detection result, the second signal detection result, and a comparison criterion; and combine a plurality of consecutive compared signal detection results to detect the signal in the data stream supplied.

This ensures that drawbacks of the respective other signal detection algorithm can be eliminated by obtaining the signal based on the analytical signal detection algorithm and simultaneously based on the machine learning signal detection algorithm.

In other words, this enables improved detection of singals in a data stream due to deep learning improving the shortcomings of conventional detection approaches. Potential drawbacks of deep learning detection approaches at the same time can be overcome by the combination of deep learning and analytical algorithms.

In particular, the data stream maybe the result of the reception of a RF signal.

In one embodiment, the data stream comprises a recorded data stream (e.g., stored in the device or in an external device connected to the device). In other words, the data stream comprises an offline-processed data stream. That is, the device can be operated in an offline mode.

In particular, and additionally or alternatively, the data stream may be an online-processed data stream (e.g., received by a receiver and being directly provided to the device). That is, the device can be operated in an online mode.

In particular, the data stream may be represented by a frequency-over-time chart of the power. The representation may comprise at least one of: a spectrum, a spectrogram, a frequency spectrum, a Fourier transformation, In-phase and quadrature (IQ) data.

In particular, the analytical signal detection algorithm is a power-based analytical signal detection algorithm working in the frequency/time representation of the power of the data stream. That is, the analytical signal detection algorithm can detect a presence and/or position of a signal based on power information in the data stream.

In particular, the machine learning signal detection is a power-based machine learning signal detection working in the frequency/time representation of the power of the data stream. That is, the machine learning signal detection can detect a presence and/or position of a signal based on power information in the data stream.

The machine learning signal detection may be implemented by an artificial neural network trained by supervised learning. The training may be performed by training data of "detected", i.e. marked, signals in a frequency/time representation of data streams. Thus, a frequency/time resource of a signal is processed as an object.

In particular, the timeslot of the analytical signal detection algorithm and the timeslot of the machine learning signal detection algorithm relates to a same time slot.

In particular, a timeslot comprises a timeslot into which an observed data stream is divided.

In particular, the consecutive compared results are combined over time, to detect the signal. The comparison step, fusioning the results of the machine-learning and the analytical algorithm approach may operate in the frequency/time representation of the data stream, preferably in an object-recognition approach.

The comparison step may be done using an analytical approach or a machine-learning approach. The comparison algorithm may be implemented by an artificial neural network trained by supervised learning.

The machine-learning signal detection and the comparison may be implemented by a single neural network, supplied by the data stream and the detection result from the analytical signal detection and outputting identified signals and their presence in the frequency/time space.

In particular, the computing module is further configured to calculate the power values of the detected signals. A power value e.g., includes the means at which electrical energy is transferred (wired, or wirelessly), e.g., measured in the units dBm or dBpV.

In particular, the computing module is further configured to operate the first queue and the second queue simultaneously.

This ensures that the first and second signal detection result can be obtained faster, as both algorithms operate at the same time.

In an implementation form of the first aspect, the computing module is further configured to combine the plurality of consecutive compared results to detect a position of the signal in the data stream.

This ensures that not only signal detection, but also signal position detection can be improved by the combined analytical and machine learning approach.

In particular, the computing module is configured to detect the position of the signal in a time domain and/or frequency domain.

In a further implementation form of the first aspect, the analytical signal detection algorithm comprises a non-machine learning signal detection algorithm.

This ensures that one of the signal detection algorithms is based on machine learning, while the respective other algorithm is not, to exploit the benefits of both machine learning and non-machine learning techniques.

In a further implementation form of the first aspect, the selection criterion comprises at least one of: a quality metric, a result category, a confidence value, a result geometry; and/or the comparison criterion comprises at least one of: a quality metric, a result category, a confidence value, a result geometry.

This ensures that various criteria can be considered when detecting at least one signal.

In a further implementation form of the first aspect, the computing module is further configured to apply post processing to at least one of: the first signal detection result, the second signal detection result, the compared result, the combined result.

This ensures that quality of the respective result can be improved.

In a further implementation form of the first aspect, the computing module is further configured to apply preprocessing to the data stream.

This also ensures that quality of the respective result can be improved, since the quality of the underlying data stream can be improved by the preprocessing.

In a further implementation form of the first aspect, the computing module is further configured to combine compared results relating to consecutive timeslots of the data stream, to combine the consecutive compared results.

This ensures that every timeslot in the data stream is considered when obtaining the combined compare results.

A second aspect of the present invention provides a method for the detection of the frequency/time position of at least one signal in a (noise-containing, i.e. also non-signal components-containing) data stream, wherein the method comprises the steps of: in a first queue, running, by a computing module, in increments of timeslots, an analytical signal detection algorithm on the data stream to obtain a first detection result; in a second, parallel queue, running, by the computing module, in increments of timeslots, a machine learning signal detection on the data stream to obtain a plurality of signal detection results and to select a second signal detection result out of the plurality of signal detection results based on a selection criterion; determining, by the computing module, a compared signal detection result based on the first signal detection result, the second signal detection result, and a comparison criterion; and combining, by the computing module, a plurality of consecutive compared signal detection results to detect any signal in the data stream supplied.

In an implementation form of the second aspect, the method further comprises the step of combining, by the computing module, the plurality of consecutive compared results to detect a position of the signal in the data stream.

In a further implementation form of the second aspect, the analytical signal detection algorithm comprises a non-machine learning signal detection algorithm.

In a further implementation form of the second aspect, the selection criterion comprises at least one of: a quality metric, a result category, a confidence value, a result geometry; and/or the comparison criterion comprises at least one of: a quality metric, a result category, a confidence value, a result geometry.

In a further implementation form of the second aspect, the method further comprises the step of applying, by the computing module, post processing to at least one of: the first detection result, the second detection result, the compared result, the combined result.

In a further implementation form of the second aspect, the method further comprises the step of applying, by the computing module, preprocessing to the data stream.

In a further implementation form of the second aspect, the method further comprises the step of combining, by the computing module, compared results relating to consecutive timeslots of the data stream, to combine the consecutive compared results.

The second aspect and its implementation forms include the same advantages as the first aspect and its respective implementation forms.

A third aspect of the present disclosure provides a computer program comprising instructions which, when the program is executed by a computer, cause the computer to perform the method according to the second aspects or any of its implementation forms.

The third aspect includes the same advantages as the first aspect and its respective implementation forms.

An exemplary embodiment of the invention is now further explained with respect to the drawings by way of examples only, in which
- FIG. 1: shows a schematic view of a device according to an embodiment of the present invention;
- FIG. 2: shows a schematic view of a device according to an embodiment of the present invention in more detail;
- FIG. 3: shows a schematic view of an operating scenario according to the present invention; and
- FIG. 4: shows a schematic view of a method according to an embodiment of the present invention.

### DETAILED DESCRIPTION

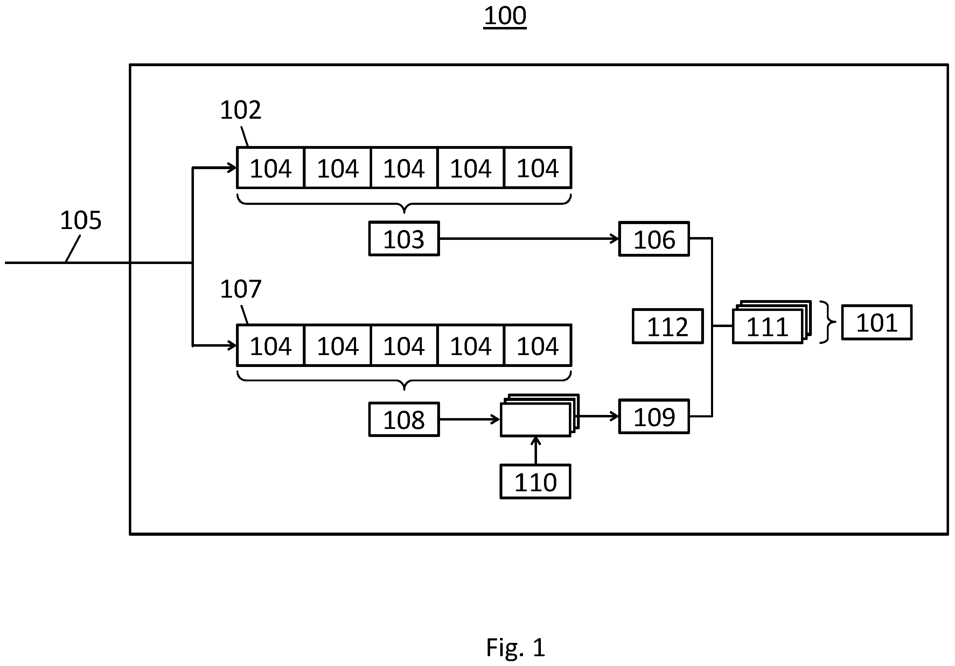

Fig. 1 shows a schematic illustration of a device 100. The device 100 is designed for the detection of at least one signal 101 in a data stream 105 supplied to the device 100. The device 100 can be operated in an offline mode, in which a pre-stored sample of the data stream can be processed. Additionally, or alternatively, the device 100 can be operated in an online mode, in which a live data stream can be processed. This e.g., includes a data stream 105 which is received at a receiver device.

In particular, the device 100 can comprise e.g., at least one of: an RF receiver or transceiver, an RF measurement device, an oscilloscope, a spectrum analyzer, or an IQ recorder.

The data stream, before being further processed in the following, is represented in a representation of the power of the data stream in the frequency/time space. Preferably, all further processing is done in this representation, such that signals are processed as objects in the sense of frequency/time resources. Thus, the signal identification is preferably performed via an object identification in the frequency/time space. Known approaches from object identification (e.g., pattern recognition) may be used for the identification, but also the combination of results.

The device 100 comprises a computing module (not shown in the figures) which is configured to, in a first queue 102, run, in increments of timeslots 104, an analytical signal detection algorithm 103 on the data stream 105 to obtain a first signal detection result 106. In other words, the first queue 102 can be regarded a sequence of measurements, wherein each measurement instance is performed on a timeslot 104 of the data stream 105. The timeslots 104 can be subsequent timeslots into which the data stream 105 is divided. When subsequent timeslots 104 are taken into account, these can be directly subsequent ones (without spaces during measurement) or indirectly subsequent ones (that is, with other timeslots in-between that are not considered by the algorithm). The analytical signal detection algorithm 103 can comprise a signal detection by power algorithm.

In a second, parallel queue 107, the computing module runs, in increments of timeslots 104, a machine learning signal detection 108 on the data stream 105 to obtain a plurality of signal detection results. The computing module then selects, based on a selection criterion 110, a second signal detection result 109 out of the plurality of signal detection results.

The selection criterion 110 can comprise at least one of: a quality metric, a result category, a confidence value, a result geometry.

In other words, also the second queue 107 can be regarded a sequence of measurement, wherein each measurement instance is performed on a timeslot 104 of the data stream 105.

The machine learning signal detection 108 may include at least one of: a convolutional neural network, a deep neural network, an artificial neural network, a recurrent neural network, a linear regression algorithm, a logistic regression algorithm, a decision tree algorithm, an SVM algorithm, a Naive Bayes algorithm, a KNN algorithm, a K-means algorithm, a random forest algorithm, a dimensionality reduction algorithm, a gradient boosting algorithm, an AdaBoosting algorithm.

Also, the machine learning signal detection algorithm 108 may be of a signal detection by power type.

The machine learning signal detection algorithm 108 may further include at least one of: a supervised learning technique, an unsupervised learning technique, a semisupervised learning technique, a reinforcement learning technique.

The selecting, based on the selection criterion 110, the second signal detection result 109 from the plurality of signal detection results can also be part of a machine learning technique.

Once the first signal detection result 106 and the second power detection result 109 are determined by the algorithms, the computing module calculates a compared signal detection result 111 based on the first signal detection result 106, the second signal detection result 109 and a comparison criterion 112.

The comparison criterion 112 can comprise at least one of: a quality metric, a result category, a confidence value, a result geometry, an area-based metric, an intersection, a union of sets, and intersection-over-union, a metric of a signal property, a signal-based metric, a center frequency metric.

To detect the signal 101 in the data stream 105 supplied to the device 100, the computing module then combines a plurality of consecutive compared signal detection results 111.

Combining the compared power detection result 111 e.g., includes calculating at least one of:
an area-based metric, an intersection, a union of sets, and intersection over union, a metric of a signal property, a signal-based metric, a center frequency metric.

The computing module may optionally be configured to employ a machine learning technique, (e.g., an artificial neural network, cluster building, or pattern recognition) to combine the plurality of consecutive compared signal detection results 111.

The combined value then indicates the at least one signal 101 in the data stream 105 supplied to the device.

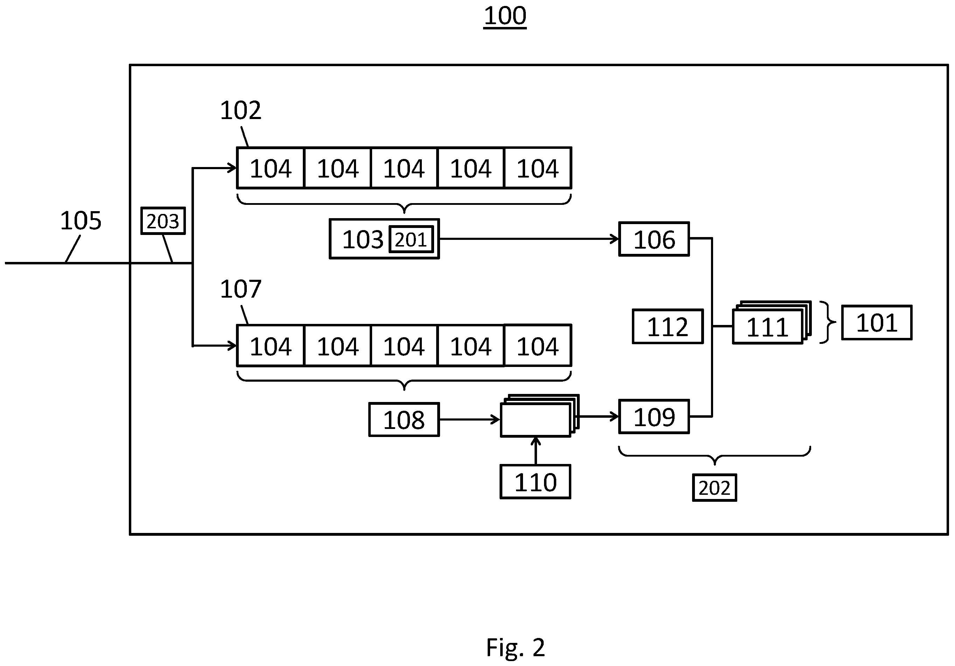

The device 100 is now going to be described in more detail in view of FIG. 2. The device 100 of FIG. 2 includes all functions and features of the system 100 as described in view of FIG. 1.

As shown in FIG. 2, the analytical signal detection algorithm 103 optionally can comprise a non-machine learning signal detection algorithm 201. That is, while the machine learning signal detection algorithm 108 is a deep learning-based algorithm, the analytical signal detection algorithm 103 explicitly is not based on a machine learning technique.

Thereby, the benefits of a machine learning based signal detection algorithm and a non-machine learning based signal detection algorithm can be combined.

Further optionally, the computing module may apply post processing 202 to at least one of: the first signal result 106, the second signal result 109, the compared result 111, the combined result. Thereby, the accuracy of the respective result can be improved.

Further optionally, the computing module may apply preprocessing to the data stream. Thereby, the accuracy of the respective result also can be improved.

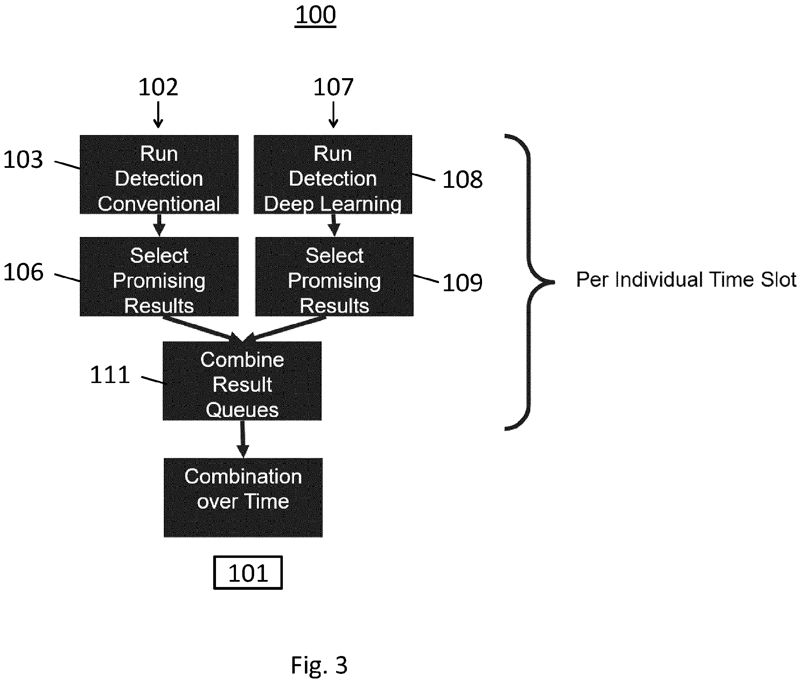

FIG. 3 shows a schematic view of an operating scenario according to the present disclosure. As shown in the figure, the device 100 combines detection results of conventional detection approaches (e.g., an energy approach, or a statistics approach) with the results of a deep learning signal detection network. Both detection approaches (that is, the first queue 102 and the second queue 107) run separately and in parallel, to deliver separate raw detection result queues (that is, the first result 106 and the second result 109) per timeslot 104. An evaluation of the raw detection result queues of both detection modes, and a selection of the most promising detection results for both queues can then be performed (thereby, the compared signal detection result 111 is calculated). A combination of distinct individual results of both queues to one common detection result queue is performed subsequently. In other words, the at least one signal 101 in the data stream 105 is detected by combining the plurality of consecutive compared signal detection results 111. In particular, all compared signal detection results 111 of all consecutive timeslots 104 can be combined over time.

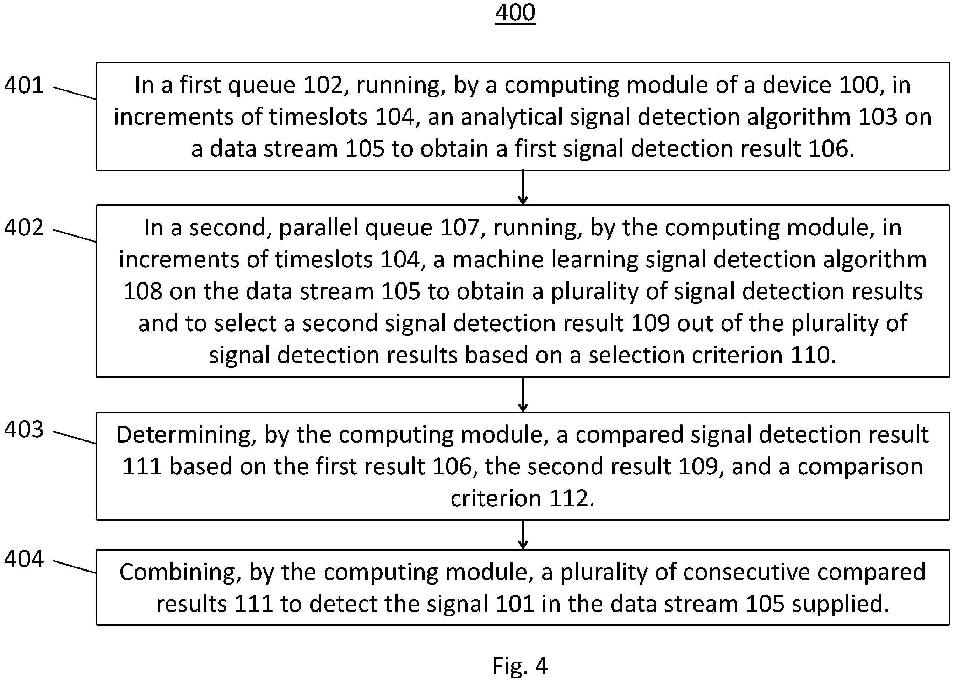

FIG. 4 shows a method 400 for combined detection of at least one signal 101 in a data stream 105 supplied to a device 100. The method 400 comprises a first step of, in a first queue 102, running 401, by a computing module of the device 100, in increments of timeslots 104, an analytical signal detection algorithm 103 on the data stream 105 to obtain a first detection result 106. The method 400 comprises a second step of, in a second, parallel queue 107, running 402, by the computing module, in increments of timeslots 104, a machine learning signal detection algorithm 108 on the data stream 105 to obtain a plurality of signal detection results and to select a second signal detection result 109 out of the plurality of signal detection results based on a selection criterion 110. The method comprises a third step of determining 403, by the computing module, a compared signal detection result 111 based on the first result 106, the second result 109, and a comparison criterion 112. The method comprises a fourth step of combining 404, by the computing module, a plurality of consecutive compared results 111 to detect the signal 101 in the data stream 105 supplied.

It is important to note that the inventive device and method very closely correspond. Therefore, all the above said regarding the device is also applicable to the method. Everything which is described in the description and/or claimed in the claims and/or drawn in the drawings can be combined.

The invention is not limited to the illustrated embodiment. The network devices may be mobile terminals such as mobile phones, but also computers such as personal computers or the like. All features described above, or features shown in the figures can be combined with each other in any advantageous manner within the scope of the invention.

## Claims

1. A device (100) for the detection of the presence and frequency/time position of at least one signal (101) in a data stream (105), also containing non-signal components, supplied wirelessly or wire-bound to the device (100), wherein the device (100) has a computing module which is configured to:
- in a first queue (102), run, in increments of timeslots (104), an analytical signal detection algorithm (103) on the data stream (105) to obtain a first signal detection result (106);
- in a second, parallel queue (107), run in increments of timeslots (104), a machine learning signal detection (108) on the data stream (105) to obtain a plurality of signal detection results and to select a second signal detection result (109) out of the plurality of signal detection results based on a selection criterion (110);
- determine a compared signal detection result (111) based on the first signal detection result (106), the second signal detection result (109), and a comparison criterion (112); and
- combine a plurality of consecutive compared results (111) to detect the presence and frequency/time position of one or more signals (101) in the data stream (105) supplied.

2. The device (100) according to claim 1, wherein the computing module is further configured to combine the plurality of consecutive compared results (111) to detect a position of the signal (101) in the data stream (105).

3. The device (100) according to claim 1 or 2, wherein the analytical signal detection algorithm (103) comprises a non-machine learning signal detection algorithm (201).

4. The device (100) according to any one of the preceding claims, wherein the selection criterion (110) comprises at least one of: a quality metric, a result category, a confidence value, a result geometry; and/or
wherein the comparison criterion (112) comprises at least one of: a quality metric, a result category, a confidence value, a result geometry, an area-based metric, an intersection, a union of sets, and intersection over union, a metric of a signal property, a signal-based metric, a center frequency metric.

5. The device (100) according to any one of the preceding claims, wherein the computing module is further configured to apply post-processing (202) to at least one of: the first signal detection result (106), the second signal detection result (109), the compared result (111), the combined result.

6. The device (100) according to any one of the preceding claims, wherein the computing module is further configured to apply pre-processing (203) to the data stream (105).

7. The device (100) according to any one of the preceding claims, wherein the computing module is further configured to combine compared results (111) relating to consecutive timeslots (104) of the data stream (105), to combine the consecutive compared results (111).

8. A method (400) for combined detection of a signal (101) in a data stream (105) supplied to a device (100), wherein the method (400) comprises the steps of:
- in a first queue (102), running (401), by a computing module of the device (100), in increments of timeslots (104), an analytical signal detection algorithm (103) on the data stream (105) to obtain a first signal detection result (106);
- in a second, parallel queue (107), running (402), by the computing module, in increments of timeslots (104), a machine learning signal detection (108) on the data stream (105) to obtain a plurality of signal detection results and to select a second signal detection result (109) out of the plurality of signal detection results based on a selection criterion (110);
- determining (403), by the computing module, a compared signal detection result (111) based on the first signal detection result (106), the second signal detection result (109), and a comparison criterion (112); and
- combining (404), by the computing module, a plurality of consecutive compared results (111) to detect the signal (101) in the data stream (105) supplied.

9. The method (400) according to claim 8, further comprising the step of combining, by the computing module, the plurality of consecutive compared results (111) to detect a frequency/time position of the signal (101) in the data stream (105).

10. The method (400) according to claim 8 or 9, wherein the analytical signal detection algorithm (103) comprises a non-machine learning signal detection algorithm (201).

11. The method (400) according to any one of claims 8 to 10, wherein the selection criterion (110) comprises at least one of: a quality metric, a result category, a confidence value, a result geometry; and/or
wherein the comparison criterion (112) comprises at least one of: a quality metric, a result category, a confidence value, a result geometry, an area-based metric, an intersection, a union of sets, and intersection over union, a metric of a signal property, a signal-based metric, a center frequency metric.

12. The method (400) according to any one of claims 8 to 11, further comprising the step of applying, by the computing module, post processing (202) to at least one of: the first signal detection result (106), the second signal detection result (109), the compared result (111), the combined result.

13. The method (400) according to any one of claims 8 to 12, further comprising the step of applying, by the computing module, preprocessing (203) to the data stream (105).

14. The method (400) according to any one of claims 8 to 13, further comprising the step of combining, by computing module, compared results (111) relating to consecutive timeslots (104) of the data stream (105), to combine the consecutive compared results (111).

15. A computer program comprising instructions which, when the program is executed by a computer, cause the computer to carry out the method (400) according to any one of claims 8 to 14.
